# EUROPEAN PATENT APPLICATION

(11) **EP 2 639 096 A1**
(43) Date of publication of application: **18.09.2013**
(21) Application number: 11839808.0
(22) Date of filing: 17.10.2011
(51) Int. Cl.: B60L 3/00, B60L 11/18, G01R 31/36, H01M 10/42, H01M 10/48, H02J 7/00

(54) **DIAGNOSIS APPARATUS FOR VEHICLE BATTERY**

(30) Priority: 10.11.2010 JP 2010251648
(71) Applicant: Nissan Motor Co., Ltd, Yokohama-shi, Kanagawa 221-0023 (JP)
(72) Inventor: FUJITA, Takeshi, Kanagawa 243-0123 (JP); HIROSE, Hideaki, Kanagawa 243-0123 (JP); HIDAKA, Masanobu, Kanagawa 243-0123 (JP); GOTO, Hironao, Kanagawa 243-0123 (JP); SAKURAI, Toshimine, Kanagawa 243-0123 (JP); SHIMAYAMA, Takashi, Kanagawa 243-0123 (JP)
(74) Representative: Hoefer & Partner
(86) International application number: PCT/JP2011/073834
(87) International publication number: WO 2012/063606

(57) **Abstract**

Provided is a diagnosis apparatus (1) for a vehicle battery, which diagnoses the history of the used state of a rechargeable battery (V1) mounted on a vehicle (V), and presents to the vehicle (V) measures to be taken to inhibit deterioration of the battery, and which is equipped with: a storing means (13) for storing therein substitution inhibiting measures to be taken for the cause of the deterioration of the battery; and a diagnosing means (14) for prohibiting, when the extracted substitution inhibiting measures to be taken does not satisfy a prescribed presentation criterion, the presentation of the measures to be taken.

## Description

### Technical Field

The present invention relates to a vehicle battery diagnosis apparatus.

### Background Art

Among diagnosis apparatuses that diagnose a secondary battery mounted in an electric vehicle, there is known an apparatus that presents a plurality of control plans for extending the life of a battery on the basis of diagnostic information, which includes usage conditions of the battery, and that updates vehicle control information so that the vehicle control information corresponds to a control plan selected by a user (PTL 1).

### Citation List

### Patent Literature

PTL 1: Japanese Unexamined Patent Application Publication No. 2010-119223

### Summary of Invention

### Technical Problem

However, the above-described diagnosis apparatus according to the related art has a problem that, though the life of the battery is extended, a control plan which imposes restrictions on a user is presented, and thus the existence value of a vehicle is decreased.

An object of the present invention is to suppress both degradation of a battery and a decrease in the existence value of a vehicle.

### Solution to Problem

In the present invention, in the case of diagnosing a history of a usage state of a battery and presenting a suppression measure against battery degradation, presentation of an alternative suppression measure is prohibited if the alternative suppression measure for a factor responsible for degradation does not satisfy a presentation criterion, and thereby the above-described object is achieved.

### Advantageous Effects of Invention

According to the present invention, even if there is an alternative suppression measure for a factor responsible for degradation, the alternative suppression measure is not presented if it does not satisfy a presentation criterion. Thus, degradation of a battery can be suppressed without decreasing the existence value of a vehicle.

### Brief Description of Drawings

[Fig. 1] Fig. 1 is a block diagram illustrating a vehicle battery diagnosis system to which an embodiment of the present invention is applied.
[Fig. 2] Fig. 2 is a diagram illustrating the relationship among main factors responsible for battery degradation, factors related to use by a user, and suppression measures against battery degradation to be presented which are applied to a vehicle battery diagnosis apparatus in Fig. 1.

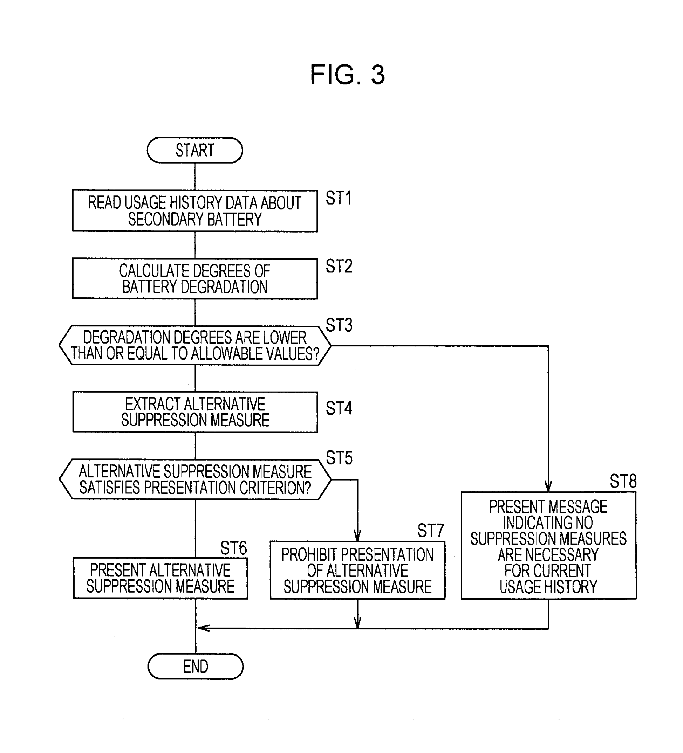

[Fig. 3] Fig. 3 is a flowchart illustrating a process performed by the vehicle battery diagnosis apparatus in Fig. 1.
[Fig. 4] Fig. 4 is a diagram illustrating an example of suppression measures against battery degradation (battery advice sheet) output from the vehicle battery diagnosis apparatus in Fig. 1.

### Description of Embodiments

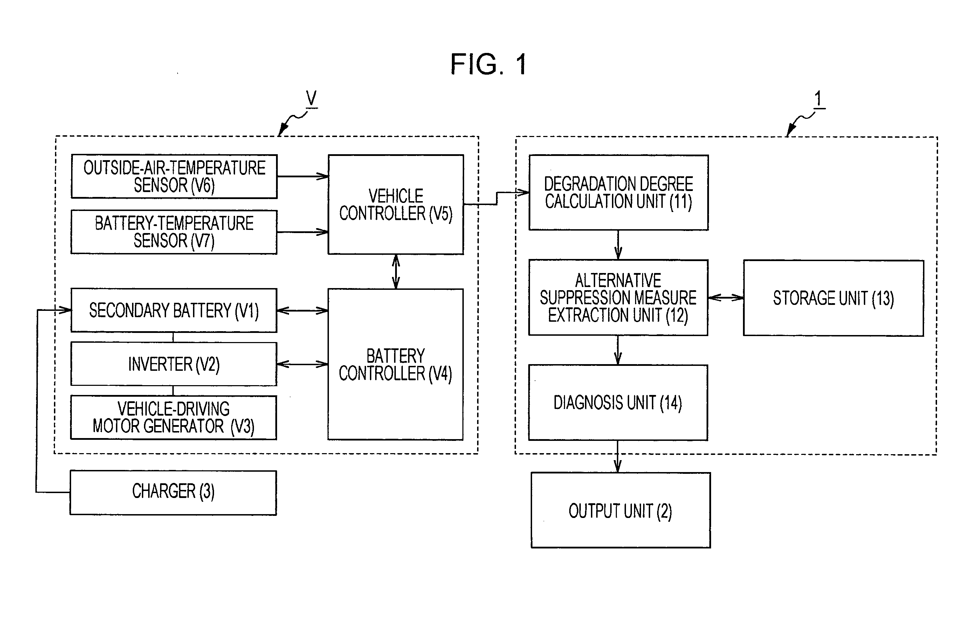

Hereinafter, an embodiment of the present invention will be described with reference to the drawings. Fig. 1 is a block diagram illustrating a vehicle battery diagnosis system to which an embodiment of the present invention is applied, and is a diagnosis system that diagnoses a history of a usage state of a secondary battery mounted in an electric vehicle which uses only a motor or a motor generator as a driving source, or a hybrid vehicle which uses a motor or a motor generator and an internal combustion engine as a driving source, and that presents a suppression measure against battery degradation. V denotes a vehicle, and 1 denotes a diagnosis apparatus.

A secondary battery V1 is a lithium-ion secondary battery or a nickel-hydride secondary battery that supplies power mainly to a vehicle-driving motor generator V3. The secondary battery V1 may supply power to a vehicle-mounted device other than the vehicle-driving motor generator V3, for example, a heater of an air conditioner, a compressor-driving motor, and an electrical device. Direct-current power of the secondary battery V1 is converted to alternating-current power by an inverter V2, and is supplied to the vehicle-driving motor generator V3, which is a three-phase alternating-current motor. When the vehicle-driving motor generator V3 shifts to a regeneration mode, alternating-current power generated by the vehicle-driving motor generator V3 is converted to direct-current power by the inverter V2, and is stored in the secondary battery V1.

A state of charge (SOC) of the secondary battery V1 is detected by a battery controller V4 and is output to a vehicle controller V5. The vehicle controller V5 calculates an output torque required for the vehicle-driving motor generator V3 on the basis of the amount of pressing down of an accelerator pedal by a driver, and outputs the calculation result to the battery controller V4. The battery controller V4 controls the inverter V2, and thereby supplies power corresponding to the required torque to the vehicle-driving motor generator V3.

The secondary battery V1 can be charged by being connecting to a charger 3, which is provided in a charging stand or a house of a user. As charging modes, a normal charging mode in which charging is performed at a voltage of about 100 to 200 V over a relatively long time, and a quick charging mode in which charging is performed by applying a high voltage of about 200 V over a relatively short time are set. The normal charging mode or the quick charging mode is selected in accordance with the specifications of a charging inlet on the vehicle side and the charger 3 of the charging stand or the like. The battery controller V4 counts the number of times charging in the normal charging mode has been performed on the vehicle, the number of times charging in the quick charging mode has been performed on the vehicle, and the total number of times charging in the normal charging mode or the quick charging mode has been performed on the vehicle, and records the count result.

At the time of charging the secondary battery V1, the user can select either of a standard-life mode in which charging continues till the SOC becomes 100%, and a long-life mode in which the SOC is limited to 80% or less. In accordance with the setting performed by the user, the battery controller V3 controls the SOC at the time of charging. That is, in a case where charging is performed in the long-life mode, charging is stopped when the SOC of the secondary battery V1 reaches 80%, and further charging is prohibited.

Temperature data supplied from an outside-air-temperature sensor V6 for detecting an outside air temperature and a battery-temperature sensor V7 for detecting a temperature of the secondary battery V1 is input, as a factor related to degradation of the secondary battery V1 (correlated to a decrease in battery capacity), to the vehicle controller V5. The outside-air-temperature sensor V6 is provided outside the vehicle, and the battery-temperature sensor V7 is provided in a module pack or the like of the secondary battery V1.

At the time of driving the vehicle, the user can select either of standard-mode driving in which the output of the vehicle-driving motor generator V3 is not limited, and an eco-mode driving in which the output of the vehicle-driving motor generator V3 is limited and economical efficiency is high. In accordance with the setting performed by the user, the vehicle controller V5 controls the output of the vehicle-driving motor generator V3. That is, in a case where the vehicle is driven using eco-mode driving, the power output to the vehicle-driving motor generator V3 is limited to a certain value even if the amount of pressing down of the accelerator pedal is large, and power supply over the certain value is prohibited. Note that, when eco-mode driving is selected, the power output to electrically-powered devices other than the vehicle-driving motor generator V3 (heater, compressor motor, electrical device, etc.) may also be limited. The vehicle controller V5 records an average value of power output to the vehicle-driving motor generator V3 in each term of driving: from when an ignition key is turned on to when the ignition key is turned off.

The battery controller V4 records the date of manufacture of the secondary battery V1, the time period from the date of manufacture to the present, and the time period over which the secondary battery V1 was left in a certain SOC or more (for example, SOC = 90%). Also, the battery controller V4 records the SOC at the time when a charging operation by the charger 3 started, and the number of times charging has been performed.

Next, the diagnosis apparatus 1 will be described. The diagnosis apparatus 1 according to this example includes a degradation degree calculation unit 11, an alternative suppression measure extraction unit 12, a storage unit 13, and a diagnosis unit 14. These units can be constituted by a microcomputer including a CPU, a ROM, a RAM, and so forth.

The degradation degree calculation unit 11 receives history data about a usage state related to a factor responsible for degradation of the secondary battery V1, and calculates the degrees of battery degradation by using the history data about the usage state. Specifically, the degradation degree calculation unit 11 calculates quick charging frequency A, charge level frequency at the start of charging B, power consumption frequency C, and left-at-high-charge-level duration rate D, and also calculates a battery temperature at the start of charging, the relationship between an outside air temperature and a battery temperature, and a battery temperature at the start of driving.

Quick charging frequency A is one of the degrees of battery degradation which is defined by (Nq/N) × 100, where Nq represents the number of times quick charging has been performed, and N represents the total number of times charging has been performed, and is a characteristic value in which the degree of battery degradation increases as quick charging frequency A increases. The number of times quick charging has been performed Nq and the total number of times charging has been performed N are read out from a memory of the battery controller V4 via the vehicle controller V5.

Charge level frequency at the start of charging B is one of the degrees of battery degradation which is defined by ∫(Fn × αn)dSOC, where Fn represents a charging frequency of each SOC at the start of charging, and αn represents a weight coefficient of each SOC, and is a characteristic value in which the degree of battery degradation increases as charge level frequency at the start of charging B increases.

For example, SOC is divided into sections in units of 20%, that is, 0 to 20%, 20 to 40%, 40 to 60%, 60 to 80%, and 80 to 100%, and the frequencies of the SOC level at the start of charging in the individual sections are counted. Also, because the degree of battery degradation increases if charging is performed when SOC is in a high level, a weight coefficient when SOC is in a high level is set to be large, and a weight coefficient when SOC is in a middle to low level is set to be small. Then, the total sum of the values which are obtained by multiplying charging start frequencies in the individual sections by respective coefficients is calculated, and thereby charge level frequency at the start of charging B is calculated. The charging frequency of each SOC at the start of charging Fn and the weight coefficient αn are read out from the memory of the battery controller V4 via the vehicle controller V5.

Power consumption frequency C is one of the degrees of battery degradation which is defined by W × β, where W represents average output power of the secondary battery V1 during certain driving, such as one trip from when an ignition key is turned on to when the ignition key is turned off, and β represents a weight coefficient, and is a characteristic value in which the degree of battery degradation increases as power consumption frequency C increases. The weight coefficient β increases as the average output power W increases. The average output power W of the secondary battery V1 during one trip and the weight coefficient β are read out from the memory of the battery controller V4 via the vehicle controller V5.

Left-at-high-charge-level duration rate D is one of the degrees of battery degradation which is defined by t/t₀, where t represents the time period over which the secondary battery V1 is left unused in a state of a certain SOC (for example, 90%) or more, and to represents the elapsed time from the date of manufacture of the battery to the present, and is a characteristic value in which the degree of battery degradation increases as left-at-high-charge-level duration rate D increases. The time period t over which the secondary battery V1 is left unused in a state of the certain SOC or more and the elapsed time to from the date of manufacture of the battery to the present are read out from the memory of the battery controller V4 via the vehicle controller V5.

The alternative suppression measure extraction unit 12 extracts an alternative suppression measure which is stored in the storage unit 13, for a factor which exceeds a certain allowable value among the degrees of degradation calculated by the degradation degree calculation unit 11. The storage unit 13 stores alternative suppression measures for factors responsible for battery degradation.

Now, factors responsible for degradation of the secondary battery V1 will be described.

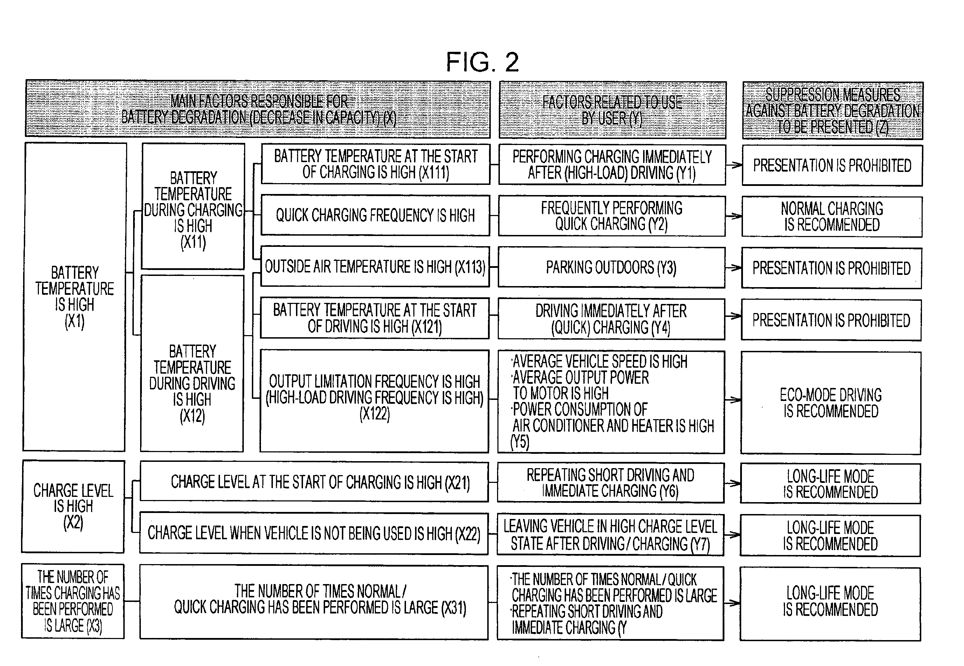

Fig. 2 is a diagram illustrating the relationship among main factors responsible for battery degradation X, factors related to use by a user Y, and suppression measures against battery degradation Z, and illustrates that the main factors responsible for battery degradation are associated with the factors related to use by a user. Degradation of the secondary battery V1, which emerges mainly as a decrease in capacity, is mainly caused by "battery temperature is high X₁", "charge level is high X₂" and "the number of times charging has been performed is large X₃". Whether the charge level is high or low is determined in accordance with SOC.

The factor "battery temperature is high X₁" includes "battery temperature during charging is high X₁₁" and "battery temperature during driving is high X₁₂". The factor "battery temperature during charging is high X₁₁" includes "battery temperature at the start of charging is high X₁₁₁", "quick charging frequency is high X₁₁₂", and "outside air temperature is high X₁₁₃". The factor "battery temperature during driving is high X₁₂" includes "outside air temperature is high X₁₁₃", "battery temperature at the start of driving is high X₁₂₁", and "output limitation frequency of the secondary battery V1 is high X₁₂₂".

The factor "battery temperature at the start of charging is high X₁₁₁" is strongly correlated to the factor related to use "performing charging immediately after driving, particularly after high-load driving Y₁". Also, the factor "quick charging frequency is high X₁₁₂" is strongly correlated to the factor related to use "frequently performing quick charging Y₂", the factor "outside air temperature is high X₁₁₃" is strongly correlated to the factor related to use "parking outdoors Y₃", the factor "battery temperature at the start of driving is high X₁₂₁" is strongly correlated to the factor related to use "driving immediately after charging, particularly after quick charging Y₄", and the factor "output limitation frequency is high X₁₂₂" is strongly correlated to the factor related to use "average vehicle speed is high, average output power to the motor generator V₃ is high, and power consumption of the air conditioner and heater is high Y₅".

The factor "charge level is high X₂" includes "charge level at the start of charging is high X₂₁" and "charge level when the secondary battery V1 is not being used is high X₂₂". The factor "charge level at start of charging is high X₂₁" is strongly correlated to the factor related to use "repeating short-distance driving (hereinafter referred to as short driving) and immediate charging Y₆", and the factor "charge level when the secondary battery V1 is not being used is high X₂₂" is strongly correlated to the factor related to use "leaving the vehicle in high charge level state after driving or charging Y₇".

The factor "the number of times charging has been performed is large X₃" includes "the number of times normal charging or quick charging has been performed is large X₃₁". The factor "the number of times normal charging or quick charging has been performed is large X₃₁" is strongly correlated to the factor related to use "the number of times normal or quick charging has been performed is large, and repeating short driving and immediate charging Y₈".

The factors related to use by a user Y1 to Y8 illustrated in Fig. 2 are responsible for degradation of the secondary battery V1 in any event. Thus, it is desirable to set, as a suppression measure against battery degradation, a usage method for eliminating or reducing the factors related to use. For this purpose, in this example, the following suppression measures are stored in the storage unit 13 illustrated in Fig. 1.

That is, a suppression measure "avoiding charging immediately after driving" for the factor related to use "performing charging immediately after driving, particularly after high-load driving Y₁"; a suppression measure "recommending normal charging instead of quick charging" for the factor related to use "frequently performing quick charging Y₂"; a suppression measure "avoiding parking outdoors" for the factor related to use "parking outdoors Y₃"; a suppression measure "avoiding driving immediately after charging" for the factor related to use "driving immediately after charging, particularly after quick charging Y₄"; a suppression measure "recommending eco-mode driving for limiting power consumption" for the factor related to use "average vehicle speed is high, average output power to the motor generator V₃ is high, and power consumption of the air conditioner and heater is high Y₅"; a suppression measure "recommending a long-life mode for limiting a full-charge level" for the factor related to use "repeating short driving and immediate charging Y₆"; a suppression measure "recommending a long-life mode for limiting a full-charge level" for the factor related to use "leaving the vehicle in high charge level state after driving or charging Y₇"; and a suppression measure "recommending a long-life mode for limiting a full-charge level" for the factor related to use "the number of times normal or quick charging has been performed is large, and repeating short driving and immediate charging Y₈", are stored in the storage unit 13.

The alternative suppression measure extraction unit 12 illustrated in Fig. 1 extracts an alternative suppression measure which is stored in the storage unit 13, for a factor which exceeds a certain allowable value among the degrees of degradation calculated by the degradation degree calculation unit 11. Note that the allowable value used as a determination criterion in the degradation degree calculation unit 11 can be arbitrarily set in accordance with the degrees of degradation represented by quick charging frequency A, charge level frequency at the start of charging B, power consumption frequency C, and left-at-high-charge-level duration rate D.

The diagnosis unit 14 permits output of an alternative suppression measure extracted by the alternative suppression measure extraction unit 12 to the output unit 2 as a suppression measure if the alternative suppression measure satisfies a certain presentation criterion, and prohibits presentation of the alternative suppression measure as a suppression measure if the alternative suppression measure does not satisfy the presentation criterion. The diagnosis unit 14 sets, as the presentation criterion, whether or not a function of the vehicle is impaired. If the alternative suppression measure extracted by the alternative suppression measure extraction unit 12 impairs a function of the vehicle, the diagnosis unit 14 prohibits presentation of the alternative suppression measure. If the alternative suppression measure impairs a performance of the vehicle but does not impair a function of the vehicle, the diagnosis unit 14 permits presentation of the alternative suppression measure. In other words, the diagnosis unit 14 prohibits presentation of an alternative suppression measure which prohibits use or parking of the vehicle, an alternative suppression measure which prohibits charging of the secondary battery, and an alternative suppression measure related to a natural environment, because these alternative suppression measures impair a function of the vehicle.

That is, the diagnosis unit 14 prohibits presentation of the suppression measure "avoiding charging immediately after driving" for the factor related to use "performing charging immediately after driving, particularly after high-load driving Y₁", among the above-described suppression measures, because this is an alternative suppression measure which prohibits charging of the battery. Also, the diagnosis unit 14 prohibits presentation of the suppression measure "avoiding parking outdoors" for the factor related to use "parking outdoors Y₃", because this is an alternative suppression measure related to a natural environment, and prohibits presentation of the suppression measure "avoiding driving immediately after charging" for the factor related to use "driving immediately after charging, particularly after quick charging Y₄", because this is an alternative suppression measure which prohibits use of the vehicle. In addition, the diagnosis unit 14 prohibits presentation of the suppression measure "avoiding leaving the vehicle in a high charge level" for the factor related to use "leaving the vehicle in high charge level state after driving or charging Y₇", because this is an alternative suppression measure which prohibits parking of the vehicle.

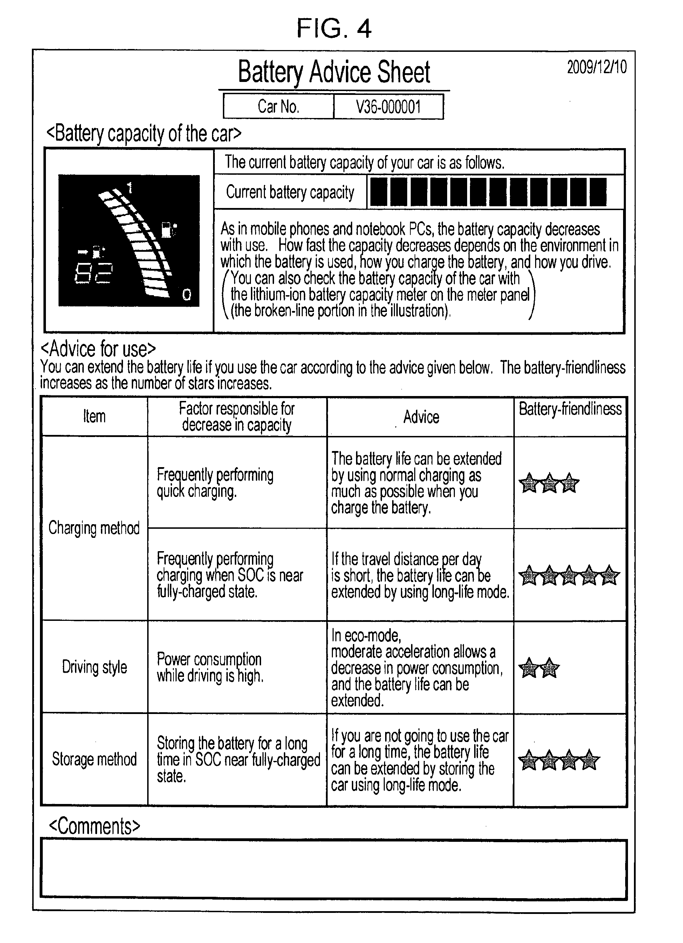

The output unit 2 is constituted by a printer which outputs an alternative suppression measure output from the diagnosis unit 14 onto a paper medium, a display which displays an alternative suppression measure, or the like, and has a function of presenting an alternative suppression measure to the user. Fig. 4 illustrates an advice sheet, which is a display example.

The advice sheet illustrated in Fig. 4 includes, as the items of "advice for use", charging method, driving style, and storage method, and also includes, as the factors responsible for a decrease in capacity, "frequently performing quick charging", "frequently performing charging when SOC is near fully-charged state", "power consumption while driving is high", and "storing the battery for a long time in SOC near fully-charged state". These items and the factors responsible for a decrease in capacity are not changed by a usage state of a user, and are thus output as fixed display items. In contrast, the output content of the items "advice" and "battery-friendliness" changes in accordance with a usage state of a user. The details will be described below.

Next, the operation of the diagnosis apparatus 1 according to this example will be described.
First, the diagnosis apparatus 1 and the vehicle controller V5 are connected to each other, and usage history data about the secondary battery V1, which is recorded in the vehicle controller V5 and the battery controller V3, is read into the degradation degree calculation unit 11 in step ST1.

In step ST2, the degradation degree calculation unit 11 calculates degradation degrees, such as quick charging frequency A, charge level frequency at the start of charging B, power consumption frequency C, left-at-high-charge-level duration rate D, the battery temperature at the start of charging, the relationship between an outside air temperature and a battery temperature, and the battery temperature at the start of driving, on the basis of the read usage history data about the secondary battery V1. In step ST3, the alternative suppression measure extraction unit 12 determines whether or not the individual calculation results of quick charging frequency A, charge level frequency at the start of charging B, power consumption frequency C, left-at-high-charge-level duration rate D, the battery temperature at the start of charging, the relationship between an outside air temperature and a battery temperature, and the battery temperature at the start of driving are lower than or equal to certain allowable values.

As a result of the determination performed in step ST3, the process proceeds to step ST8 for a degradation factor which is lower than or equal to the allowable value, and presents a message indicating that no suppression measures are necessary for the current usage history. Specifically, "The method which is currently being used does not have a factor responsible for a decrease in capacity." is displayed in the advice item of the advice sheet in Fig. 4, and many stars are displayed in the item of battery-friendliness.

As a result of the determination performed in step ST3, the process proceeds to step ST4 for a degradation factor which exceeds the allowable value, among quick charging frequency A, charge level frequency at the start of charging B, power consumption frequency C, left-at-high-charge-level duration rate D, the battery temperature at the start of charging, the relationship between an outside air temperature and a battery temperature, and the battery temperature at the start of driving, and an alternative suppression measure stored in the storage unit 13 is extracted.

In step ST5, it is determined whether or not the alternative suppression measure extracted in step ST4 satisfies the above-described presentation criterion. Specifically, if the alternative suppression measure extracted by the alternative suppression measure extraction unit 12 impairs a function of the vehicle, the process proceeds to step ST7, and presentation of the alternative suppression measure is prohibited. On the other hand, if the alternative suppression measure impairs a performance of the vehicle but does not impair a function of the vehicle, the process proceeds to step ST6, and presentation of the alternative suppression measure is permitted.

In the advice sheet illustrated in Fig. 4, alternative suppression measures for the case where all of quick charging frequency A, charge level frequency at the start of charging B, power consumption frequency C, and left-at-high-charge-level duration rate D exceed the allowable values are presented. That is, normal charging is recommended to the user because quick charging frequency A exceeds the allowable value, the long-life mode is recommended to the user because charge level frequency at the start of charging B exceeds the allowable value, eco-mode driving is recommended to the user because power consumption frequency C exceeds the allowable value, and the long-life mode is recommended to the user because left-at-high-charge-level duration rate D exceeds the allowable value. In the item of battery-friendliness in the advice sheet illustrated in Fig. 4, battery-friendliness increases as the number of stars increases. In Fig. 4, a state where the number of stars does not match the content of advice is also displayed for convenience.

Also, in the example illustrated in Fig. 4, the battery temperature at the start of charging, the battery temperature at the start of driving, and the outside air temperature also exceed the allowable values. However, as a result of diagnosis performed by the diagnosis unit 14, suppression measures, such as prohibiting charging, driving, or parking outdoors, are not presented.

As described above, according to the diagnosis apparatus 1 of this example, as a result of analyzing a factor responsible for degradation of the secondary battery V1 by the degradation degree calculation unit 11, the alternative suppression measure extraction unit 12 extracts an alternative suppression measure for battery degradation. If the diagnosis unit 14 determines that the alternative suppression measure impairs a function of the vehicle, in other words, if the alternative suppression measure is an alternative suppression measure which prohibits use or parking of the vehicle, an alternative suppression measure which prohibits charging of the secondary battery, or an alternative suppression measure related to a natural environment, the diagnosis unit 14 prohibits presentation of the alternative suppression measure because it impairs a function of the vehicle. As a result, degradation of the secondary battery V1 can be suppressed without imposing extreme restrictions on the user and without decreasing the existent value of the vehicle.

By using quick charging frequency A, charge level frequency at the start of charging B, power consumption frequency C, and left-at-high-charge-level duration rate D which have been calculated by the above-described degradation degree calculation unit 11, quick charging frequency A and the coefficient a thereof, charge level frequency at the start of charging B and the coefficient b thereof, power consumption frequency C and the coefficient c thereof, and left-at-high-charge-level duration rate D and the coefficient d thereof, in a case where a + b + c + d = 1, a total degradation degree F which is defined by F = A × a + B × b + C × c + D × d may be output to the output unit 2.

Alternatively, the alternative suppression measures stored in the storage unit 13, the allowable values for the alternative suppression measure extraction unit 12, and the presentation criterion for the diagnosis unit 14 may be received from the outside of the diagnosis apparatus 1 and may be periodically updated. Furthermore, the diagnosis apparatus 1 is provided separately from the vehicle V in the example in Fig. 1, but the diagnosis apparatus 1 may be mounted in the vehicle, and the output unit 2 may be shared with a vehicle-mounted display of a navigation system, and a diagnosis result may be displayed on the display. Alternatively, the diagnosis apparatus 1 may be installed in a global data center, and communication with a vehicle-mounted computer may be performed by using telematics, so that display on a vehicle-mounted display or printout in the global center may be performed.

In the above-described embodiment, if the degradation degree calculated by the degradation degree calculation unit 11 exceeds a certain allowable value, the corresponding alternative suppression measure is extracted by the alternative suppression measure extraction unit 12, and, if the extracted alternative suppression measure does not satisfy the presentation criterion, the diagnosis unit 14 prohibits the presentation thereof. Alternatively, the diagnosis unit 14 may prohibit presentation of an alternative suppression measure if the alternative suppression measure does not satisfy the presentation criterion, and may permit presentation of an alternative suppression measure if the alternative suppression measure satisfies the presentation criterion, regardless of whether or not the degradation degree of the secondary battery V1 exceeds the certain allowable value, or independently of the determination. In this case, the degradation degree calculation unit 11 and the alternative suppression measure extraction unit 12 are not always necessary, and these units may be omitted. Alternatively, independently of a determination performed by the diagnosis unit 14, history data about a usage state of the secondary battery V1 may be read into the degradation degree calculation unit 11 from the vehicle controller V5, and a result about a degradation degree may be output to the output unit 2.

The above-described degradation degree calculation unit 11 corresponds to degradation degree calculation means and total degradation degree presentation means according to the present invention, the above-described alternative suppression measure extraction unit 12 corresponds to extraction means according to the present invention, the above-described storage unit 13 corresponds to storage means and update means according to the present invention, and the above-described diagnosis unit 14 corresponds to diagnosis means according to the present invention.

### Reference Signs List

- V: vehicle
- V1: secondary battery
- V2: inverter
- V3: vehicle-driving motor
- V4: battery controller
- V5: vehicle controller
- V6: outside-air-temperature sensor
- V7: battery-temperature sensor
- 1: diagnosis apparatus
- 11: degradation degree calculation unit
- 12: alternative suppression measure extraction unit
- 13: storage unit
- 14: diagnosis unit
- 2: output unit
- 3: charger

## Claims

1. A vehicle battery diagnosis apparatus that diagnoses, for a vehicle having a secondary battery mounted therein, a history of a usage state of the secondary battery, and that presents a suppression measure against battery degradation, comprising:
storage means for storing an alternative suppression measure for a factor responsible for degradation of the secondary battery; and
diagnosis means for prohibiting presentation of the alternative suppression measure as a suppression measure, if the alternative suppression measure does not satisfy a certain presentation criterion.

2. The vehicle battery diagnosis apparatus according to Claim 1, further comprising:
degradation degree calculation means for receiving history data about a usage state related to a factor responsible for degradation of the secondary battery and calculating degrees of battery degradation by using the history data about the usage state; and
extraction means for extracting an alternative suppression measure from the storage means for a factor which exceeds a certain allowable value among the calculated degrees of degradation,
wherein, if the extracted alternative suppression measure does not satisfy the certain presentation criterion, the diagnosis means prohibits presentation of the alternative suppression measure as a suppression measure.

3. The vehicle battery diagnosis apparatus according to Claim 1 or 2, wherein
the factor responsible for degradation of the secondary battery includes a battery temperature, an SOC at the time of charging, and the number of times charging has been performed,
the battery temperature includes a battery temperature at the start of charging, a quick charging frequency, an outside air temperature, a battery temperature at the start of driving, and an output limitation frequency of the battery,
the SOC at the time of charging includes an SOC at the start of charging and an SOC when the battery is not being used, and
the number of times charging has been performed includes the number of times normal charging or quick charging has been performed.

4. The vehicle battery diagnosis apparatus according to any one of Claims 1 to 3, wherein
the diagnosis means sets, as the presentation criterion, whether or not a function of the vehicle is impaired, and
the diagnosis means prohibits presentation of the alternative suppression measure if the alternative suppression measure impairs a function of the vehicle, and permits presentation of the alternative suppression measure if the alternative suppression measure impairs a performance of the vehicle but does not impair a function of the vehicle.

5. The vehicle battery diagnosis apparatus according to Claim 4,
wherein the diagnosis means prohibits presentation of an alternative suppression measure which prohibits use or parking of the vehicle, an alternative suppression measure which prohibits charging of the battery, and an alternative suppression measure related to a natural environment, because the alternative suppression measures impair a function of the vehicle.

6. The vehicle battery diagnosis apparatus according to any one of Claims 2 to 5,
wherein the certain allowable value can be arbitrarily set.

7. The vehicle battery diagnosis apparatus according to any one of Claims 2 to 6,
wherein the degradation degree calculation means calculates, as the degree of battery degradation, a quick charging frequency which is defined by (Nq/N) x 100, where Nq represents the number of times quick charging has been performed, and N represents a total number of times charging has been performed.

8. The vehicle battery diagnosis apparatus according to any one of Claims 2 to 7,
wherein the degradation degree calculation means calculates, as the degree of battery degradation, a charge level frequency at the start of charging which is defined by ∫(Fn × αn)dSOC, where Fn represents a charging frequency in each SOC at the start of charging, and αn represents a weight coefficient of each SOC.

9. The vehicle battery diagnosis apparatus according to any one of Claims 2 to 8,
wherein the degradation degree calculation means calculates, as the degree of battery degradation, a power consumption frequency which is defined by W × β, where W represents average output power of the battery during certain driving, and β represents a weight coefficient.

10. The vehicle battery diagnosis apparatus according to any one of Claims 2 to 9,
wherein the degradation degree calculation means calculates, as the degree of battery degradation, a left-at-high-charge-level duration rate which is defined by t/t₀, where t represents a time period over which the battery is left unused in a state of a certain SOC or more, and to represents an elapsed time from a manufacture date of the battery to the present.

11. The vehicle battery diagnosis apparatus according to Claim 10 (depending on Claims 7, 8, and 9), further comprising:
total degradation degree presentation means for presenting a total degradation degree which is defined by A × a + B × b + C × c + D × d in a case where the quick charging frequency A and the coefficient thereof a, the charge level frequency at the start of charging B and the coefficient thereof b, the power consumption frequency C and the coefficient thereof c, the left-at-high-charge-level duration rate D and the coefficient thereof d, and a + b + c + d = 1.

12. The vehicle battery diagnosis apparatus according to any one of Claims 1 to 11, further comprising:
update means for externally receiving and updating the alternative suppression measure stored in the storage means, the allowable value for the extraction means, and the presentation criterion for the diagnosis means.

13. A vehicle including the vehicle battery diagnosis apparatus according to any one of Claims 1 to 12 mounted therein.

14. An external information center including the vehicle battery diagnosis apparatus according to any one of Claims 1 to 12 installed therein.
